# EUROPEAN PATENT APPLICATION

(11) **EP 3 943 286 A1**
(43) Date of publication of application: **26.01.2022**
(21) Application number: 20809336.9
(22) Date of filing: 15.05.2020
(51) Int. Cl.: B32B 9/00, H01L 23/36, H01L 23/373, B32B 15/04, C01B 32/194, C01B 32/20

(54) **COMPOSITE HEAT TRANSFER MEMBER AND METHOD FOR MANUFACTURING COMPOSITE HEAT TRANSFER MEMBER**

(30) Priority: 17.05.2019 JP 2019093718
(71) Applicant: Mitsubishi Materials Corporation, Tokyo 100-8117 (JP)
(72) Inventor: MAEKAWA, Takashi, Saitama-shi, Saitama 330-8508 (JP); YAMASHIMA, Susumu, Saitama-shi, Saitama 330-8508 (JP)
(74) Representative: Gille Hrabal Partnerschaftsgesellschaft mbB Patentanwälte
(86) International application number: PCT/JP2020/019477
(87) International publication number: WO 2020/235491

(57) **Abstract**

A composite heat transfer member (1) has a plate (10) and a metal cast body (20) covering a surface of the plate, and the plate (10) is made of a carbonaceous material formed of a composite containing graphite particles and graphene aggregates formed by depositing a single layer or multiple layers of graphene.

## Description

### TECHNICAL FIELD

The present invention relates to a composite heat transfer member and a method of manufacturing the composite heat transfer member. More specifically, the present invention relates to, for example, a composite heat transfer member which can efficiently transfer heat from a heating element and is particularly suitable as a heat conduction member, and a method of manufacturing the composite heat transfer member.

Priority is claimed on Japanese Patent Application No. 2019-093718, filed May 17, 2019, the content of which is incorporated herein by reference.

### BACKGROUND ART

As a heat spreader which transfers heat generated from an electronic component or an electronic device, a copper plate or a carbonaceous material in which graphene and graphite particles are laminated in one direction (hereinafter, referred to as carbonaceous material) is used.

Of these, the carbonaceous material has a higher thermal conductivity than the copper plate and has a small specific gravity, and is therefore useful as a heat spreader since it can be reduced in size and weight.

In general, the above-described carbonaceous material is brittle. Accordingly, there is concern that the carbonaceous material may be damaged by stress when it is brought into contact with a heat source such as an electronic component or an electronic device or attached to another member.

Therefore, for example, as shown in Patent Documents 1 and 2, a composite heat transfer member is used in which the above-described carbonaceous material is covered with a metal such as copper, nickel, or aluminum to increase the strength of the whole material.

### Citation List

### Patent Documents

Patent Document 1: Japanese Unexamined Patent Application, First Publication No. 2011-023670
Patent Document 2: Japanese Unexamined Patent Application, First Publication No. 2012-238733

### SUMMARY OF INVENTION

### Technical Problem

In the above-described Patent Documents 1 and 2, in the formation of a metal layer on a surface of the carbonaceous material, a titanium layer is formed on the surface of the carbonaceous material, and a nickel layer or a copper layer is formed on the titanium layer. That is, the joining strength between the carbonaceous material and the metal layer is secured by interposing the titanium layer as an active metal.

However, since titanium has a relatively low thermal conductivity of 17 W/(m·K), the titanium layer interposed between the carbonaceous material and the metal layer provides heat resistance, and there is concern that heat may not be efficiently conducted in a thickness direction.

The present invention is contrived in view of the above-described circumstances, and an object thereof is to provide a composite heat transfer member in which a plate of a carbonaceous material formed of a composite containing graphene and graphite particles and a metal cast body are strongly adhered to each other to efficiently conduct heat, and a method of manufacturing the composite heat transfer member.

### Solution to Problem

In order to solve such a problem and achieve the object, a composite heat transfer member according to the present invention is provided having a plate and a metal cast body covering a surface of the plate, in which the plate is made of a carbonaceous material formed of a composite containing graphite particles and graphene aggregates formed by depositing a single layer or multiple layers of graphene.

According to the composite heat transfer member having the above configuration, since the surface of a plate formed of a carbonaceous material formed of a composite containing graphite particles and graphene aggregates formed by depositing a single layer or multiple layers of graphene is covered with a metal cast body, the cast body is in surface contact with the surface of the plate, and due to a difference in shrinkage between the cast body and the plate during the formation of the cast body, the cast body presses the surface of the plate.

Accordingly, the cast body is strongly adhered to the surface of the plate. Therefore, the heat resistance at a joining interface between the cast body and the plate is reduced, and the thermal conductivity of the composite heat transfer member can thus be improved.

Here, in the composite heat transfer member according to the present invention, it is preferable that the carbonaceous material contain graphene aggregates formed by depositing a single layer or multiple layers of graphene, and flat graphite particles, and have a structure in which the flat graphite particles are laminated with the graphene aggregates as a binder so that basal surfaces of the graphite particles overlap with one another, and the basal surfaces of the flat graphite particles are oriented in one direction.

In this case, since the carbonaceous material has a structure in which the graphene aggregates and the graphite particles are laminated as described above, the thermal conductivity in a direction in which the basal surfaces of the graphite particles expand is increased, and heat can be efficiently transferred.

In addition, in the composite heat transfer member according to the present invention, it is preferable that the plate be provided with a through-hole, and a part of the cast body fill the through-hole.

In this case, since a part of the cast body fills the through-hole, the plate and the cast body can be more firmly joined. In addition, heat can be more efficiently transferred in a thickness direction of the plate by the cast body filling the through-hole.

Furthermore, in the composite heat transfer member according to the present invention, the plate may be accommodated in a metal tray, and the cast body may cover at least an exposed surface of the plate.

In this case, since the plate made of a carbonaceous material is accommodated in the tray, it is possible to prevent the relatively brittle plate from being damaged during handling. In addition, since the cast body covers at least the exposed surface of the plate, the cast body is strongly adhered to the surface of the plate, the heat resistance at a joining interface between the cast body and the plate is reduced, and the thermal conductivity of the composite heat transfer member can thus be improved.

In addition, in the composite heat transfer member according to the present invention, it is preferable that the plate be provided with a through-hole, the tray be provided with an opening portion communicating with the through-hole of the plate, and a part of the cast body fill the opening portion and the through-hole.

In this case, since a part of the cast body fills the opening portion of the tray and the through-hole of the plate, the tray, the plate, and the cast body can be more firmly joined.

Furthermore, in the composite heat transfer member according to the present invention, the tray and the cast body may be made of the same metal.

In this case, the tray and the cast body are integrated, and the plate made of a carbonaceous material can be reliably covered.

In addition, in the composite heat transfer member according to the present invention, fins may be provided on the cast body.

In this case, by providing the fins on the cast body covering the surface of the plate, heat radiation characteristics can be improved.

Furthermore, in the composite heat transfer member according to the present invention, the cast body may be made of pure magnesium, a magnesium alloy, pure aluminum, or an aluminum alloy.

In this case, since pure magnesium, a magnesium alloy, pure aluminum, or an aluminum alloy has a small specific gravity and an excellent heat conduction property, the composite heat transfer member can be reduced in weight and can be improved in heat conduction property.

In addition, in the composite heat transfer member according to the present invention, the carbonaceous material constituting the plate may have a structure in which the graphite particles and the graphene aggregates are laminated in a direction orthogonal to a thickness direction of the plate.

In this case, the heat conduction property in the thickness direction of the plate is particularly excellent, and heat can be efficiently transferred from one surface of the plate to the other surface side.

Furthermore, in the composite heat transfer member according to the present invention, the plate may have a first laminate formed of a carbonaceous material having a structure in which the graphite particles and the graphene aggregates are laminated in a first direction orthogonal to the thickness direction of the plate, and a second laminate formed of a carbonaceous material having a structure in which the graphite particles and the graphene aggregates are laminated in a second direction parallel to the thickness direction of the plate, and the first laminate and the second laminate may be in contact with each other in a third direction orthogonal to the first direction and the second direction.

In this case, since the direction in which the thermal conductivity is high differs between the first laminate and the second laminate, heat can be spread over the entire surface, and heat radiation characteristics can be further improved.

In addition, in the composite heat transfer member according to the present invention, a third laminate formed of a carbonaceous material having a structure in which the graphite particles and the graphene aggregates are laminated in the third direction may be provided, the cast body may cover a surface of the third laminate, and the third laminate may be in contact with the first laminate and erected from the first laminate in the second direction.

In this case, heat can be efficiently transferred from the first laminate to the second laminate via the third laminate.

A method of manufacturing a composite heat transfer member according to the present invention has a step of disposing, in a cavity of a casting mold, a plate made of a carbonaceous material formed of a composite containing graphite particles and graphene aggregates formed by depositing a single layer or multiple layers of graphene and a step of supplying a molten or semi-molten metal into the cavity to form a cast body of the metal, thereby covering the plate with the cast body.

According to the method of manufacturing a composite heat transfer member having the above configuration, the cast body is in surface contact with a surface of the plate, and due to a difference in shrinkage between the cast body and the plate during the formation of the cast body, the cast body presses the surface of the plate. Accordingly, the cast body is strongly adhered to the surface of the plate. Therefore, the heat resistance at a joining interface between the cast body and the plate is reduced, and the thermal conductivity of the composite heat transfer member can thus be improved.

Here, in the method of manufacturing a composite heat transfer member according to the present invention, it is preferable that the carbonaceous material contain graphene aggregates formed by depositing a single layer or multiple layers of graphene, and flat graphite particles, and have a structure in which the flat graphite particles are laminated with the graphene aggregates as a binder so that basal surfaces of the graphite particles overlap with one another, and the basal surfaces of the flat graphite particles are oriented in one direction.

In this case, since the carbonaceous material has a structure in which the graphene aggregates and the graphite particles are laminated as described above, the thermal conductivity in a direction in which the basal surfaces of the graphite particles expand is increased, and heat can be efficiently transferred.

In addition, in the method of manufacturing a composite heat transfer member according to the present invention, in the step of disposing the plate in the cavity, the plate may be disposed in the cavity in a state in which the plate is accommodated in a metal tray, and in the step of covering a surface of the plate with the cast body, an upper surface of the plate and an outer side surface of the tray may be covered with the cast body.

In this case, since the plate made of a carbonaceous material is accommodated in the tray, it is possible to prevent the relatively brittle plate from being damaged during manufacturing.

### ADVANTAGEOUS EFFECTS OF INVENTION

According to the present invention, it is possible to provide a composite heat transfer member in which a plate of a carbonaceous material formed of a composite containing graphene and graphite particles and a metal cast body are strongly adhered to each other to efficiently conduct heat, and a method of manufacturing the composite heat transfer member.

### BRIEF DESCRIPTION OF DRAWINGS

Fig. 1A is a perspective view illustrating a composite heat transfer member according to a first embodiment of the present invention.
Fig. 1B is a cross-sectional view of the composite heat transfer member shown in Fig. 1A.
Fig. 1C is an enlarged cross-sectional view of a portion 1C of Fig. 1B.
Fig. 1D is an enlarged cross-sectional view of a portion 1D of Fig. 1B.
Fig. 2 is an enlarged explanatory view of a carbonaceous member constituting a plate in the composite heat transfer member shown in Fig. 1A.
Fig. 3A is an explanatory view showing a part of a method of manufacturing the composite heat transfer member shown in Fig. 1A.
Fig. 3B is an explanatory view showing a part of the method of manufacturing the composite heat transfer member shown in Fig. 1A.
Fig. 3C is an explanatory view showing a part of the method of manufacturing the composite heat transfer member shown in Fig. 1A.
Fig. 3D is an enlarged cross-sectional view of a portion 3D of Fig. 3C.
Fig. 3E is an enlarged cross-sectional view of a portion 3E of Fig. 3C.
Fig. 4A is an explanatory view showing a modification example of the composite heat transfer member according to the first embodiment of the present invention.
Fig. 4B is an enlarged cross-sectional view of a portion 4B of Fig. 4A.
Fig. 4C is an enlarged cross-sectional view of a portion 4C of Fig. 4A.
Fig. 5A is a cross-sectional explanatory view of a composite heat transfer member according to a second embodiment of the present invention.
Fig. 5B is an enlarged cross-sectional view of a portion 5B of Fig. 5A.
Fig. 6 is a schematic explanatory view of a tray in the composite heat transfer member shown in Fig. 5A.
Fig. 7A is an explanatory view showing a part of a method of manufacturing the composite heat transfer member shown in Fig. 5A.
Fig. 7B is an explanatory view showing a part of the method of manufacturing the composite heat transfer member shown in Fig. 5A.
Fig. 7C is an explanatory view showing a part of the method of manufacturing the composite heat transfer member shown in Fig. 5A.
Fig. 7D is an enlarged cross-sectional view of a portion 7D of Fig. 7C.
Fig. 7E is an enlarged cross-sectional view of a portion 7E of Fig. 7C.
Fig. 8A is an explanatory view showing a modification example of the composite heat transfer member according to the second embodiment of the present invention.
Fig. 8B is an enlarged cross-sectional view of a portion 8B of Fig. 8A.
Fig. 8C is an enlarged cross-sectional view of a portion 8C of Fig. 8A.
Fig. 8D is an enlarged cross-sectional view of a portion 8D of Fig. 8A.
Fig. 8E is an enlarged cross-sectional view of a portion 8E of Fig. 8A.
Fig. 9 is an explanatory view of a plate in a composite heat transfer member according to another embodiment of the present invention.
Fig. 10 is an explanatory view of a composite heat transfer member according to a further embodiment of the present invention.
Fig. 11 is an explanatory view of a plate in a composite heat transfer member according to a further embodiment of the present invention.

### DESCRIPTION OF EMBODIMENTS

Hereinafter, embodiments of the present invention will be described with reference to the accompanying drawings. The following embodiments are specifically described in order to better understand the gist of the present invention, and do not limit the present invention unless otherwise specified. In addition, in the drawings used in the following description, in order to make the characteristics of the present invention easy to understand, the main parts may be shown in an enlarged manner, and dimensional ratios and the like of the respective constituent elements are not necessarily identical to the actual ratios and the like.

A composite heat transfer member according to this embodiment is applied to copper water cooling jackets and cooling water piping for a heat-generating component such as a central processing unit (CPU) of a server, base substrates for a power module, aluminum heat sinks for an LED head lamp for a vehicle, heat sinks for a mobile phone base station, and the like.

### (First Embodiment)

First, a composite heat transfer member 1 according to a first embodiment of the present invention will be described.

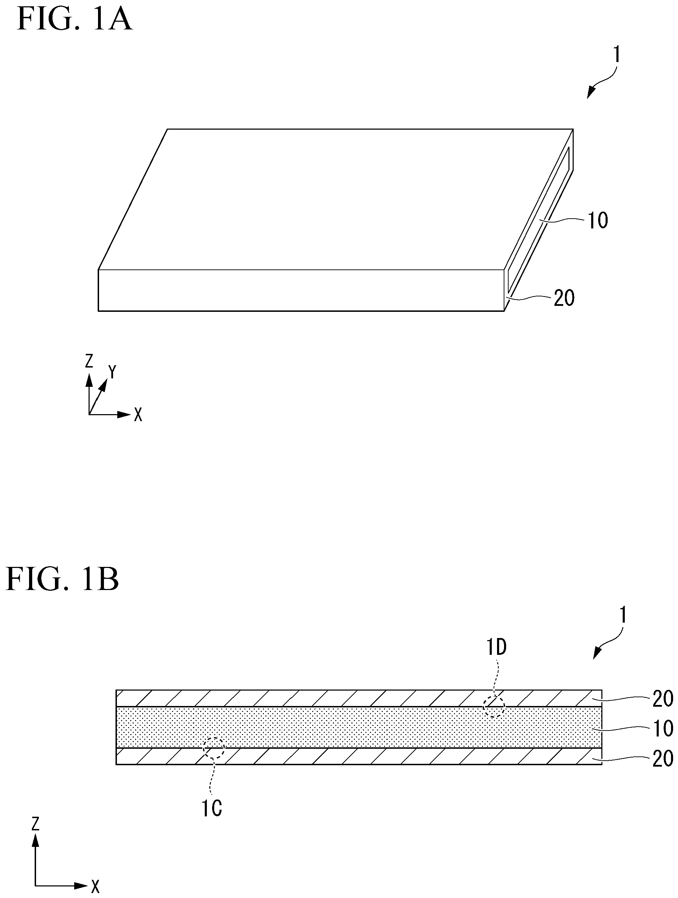

As shown in Figs. 1A and 1B, the composite heat transfer member 1 according to the embodiment of the present invention has a plate 10 formed of a carbonaceous material and a metal cast body 20 covering a surface of the plate 10.

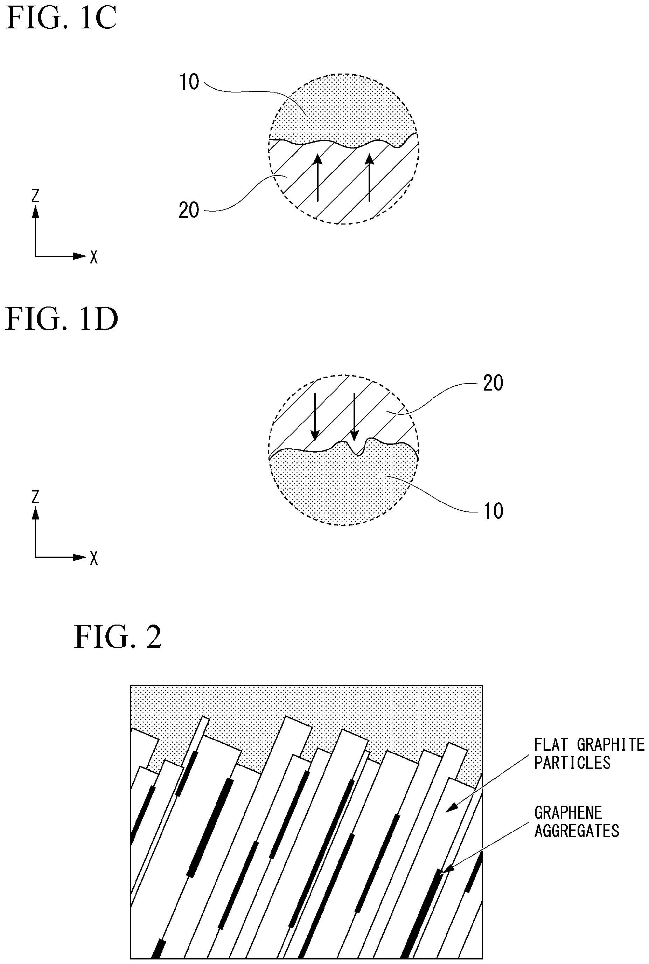

The carbonaceous material constituting the plate 10 is formed of a composite containing graphite particles and graphene aggregates formed by depositing a single layer or multiple layers of graphene. In this embodiment, as shown in Fig. 2, the carbonaceous material contains graphene aggregates formed by depositing a single layer or multiple layers of graphene, and flat graphite particles, and has a structure in which the flat graphite particles are laminated with the graphene aggregates as a binder so that the basal surfaces of the graphite particles overlap with one another.

The flat graphite particles have a basal surface on which a carbon hexagonal net surface appears and an edge surface on which an end portion of the carbon hexagonal net surface appears. As the flat graphite particles, scaly graphite, scale-like graphite, earthy graphite, flaky graphite, kish graphite, pyrolytic graphite, highly-oriented pyrolytic graphite, and the like can be used.

Here, the average particle size of the graphite particles viewed from the basal surface is preferably within a range of 10 µm or greater and 1,000 µm or less, and more preferably within a range of 50 µm or greater and 800 µm or less. The heat conduction property is improved by adjusting the average particle size of the graphite particles within the above range.

Furthermore, the thickness of the graphite particles is preferably within a range of 1 µm or greater and 50 µm or less, and more preferably within a range of 1 µm or greater and 20 µm or less. The orientation of the graphite particles is appropriately adjusted by adjusting the thickness of the graphite particles within the above range.

In addition, by adjusting the thickness of the graphite particles within a range of 1/1,000 to 1/2 of the particle size viewed from the basal surface, an excellent heat conduction property is obtained and the orientation of the graphite particles is appropriately adjusted.

The graphene aggregates are a deposit of a single layer or multiple layers of graphene, and the number of multiple layers of graphene laminated is, for example, 100 layers or less, and preferably 50 layers or less. The graphene aggregates can be produced by, for example, dripping a graphene dispersion obtained by dispersing a single layer or multiple layers of graphene in a solvent containing a lower alcohol or water onto filter paper, and depositing the graphene while separating the solvent.

Here, the average particle size of the graphene aggregates is preferably within a range of 1 µm or greater and 1,000 µm or less. The heat conduction property is improved by adjusting the average particle size of the graphene aggregates within the above range.

Furthermore, the thickness of the graphene aggregates is preferably within a range of 0.05 µm or greater and less than 50 µm. The strength of the carbonaceous member is secured by adjusting the thickness of the graphene aggregates within the above range.

Here, in this embodiment, the plate 10 has graphite particles and graphene aggregates laminated in a direction orthogonal to a thickness direction of the plate (Z direction in Figs. 1A and 1B), and the basal surfaces of the graphite particles laminated are disposed so as to extend in the thickness direction of the plate 10. Therefore, the edge surfaces of the graphite particles are directed to a main surface of the plate 10.

As described above, in a case where the edge surfaces of the graphite particles are directed to the main surface of the plate 10, relatively large irregularities are formed on the main surface of the plate 10.

In addition, as described above, since the basal surfaces of the laminated graphite particles are disposed so as to extend in the thickness direction of the plate 10, the heat conduction property in the thickness direction is excellent.

The cast body 20 is formed by cast-covering the surface of the plate 10 with a metal, as will be described later.

Here, the metal constituting the cast body 20 is not particularly limited, and is preferably pure magnesium, a magnesium alloy, pure aluminum, or an aluminum alloy having a small specific gravity and an excellent heat conduction property. In this embodiment, a magnesium alloy constitutes the cast body.

In the composite heat transfer member 1 according to this embodiment, as shown in Figs. 1B, 1C, and 1D, the cast body 20 enters the irregularities formed on the main surface of the plate 10, and thus the plate 10 and the cast body 20 are firmly joined.

That is, the magnesium alloy constituting the cast body 20 shrinks when the temperature is reduced from the solidification temperature to room temperature. At this time, the carbonaceous material constituting the plate 10 hardly shrinks or slightly expands.

As described above, in a case where a difference occurs in shrinkage between the cast body 20 and the plate 10 due to a difference in the thermal expansion coefficient, the cast body 20 presses the surface of the plate 10. Accordingly, the plate 10 and the cast body 20 are strongly adhered to each other. In Figs. 1C and 1D, the arrows indicate that the cast body 20 presses the surface of the plate 10.

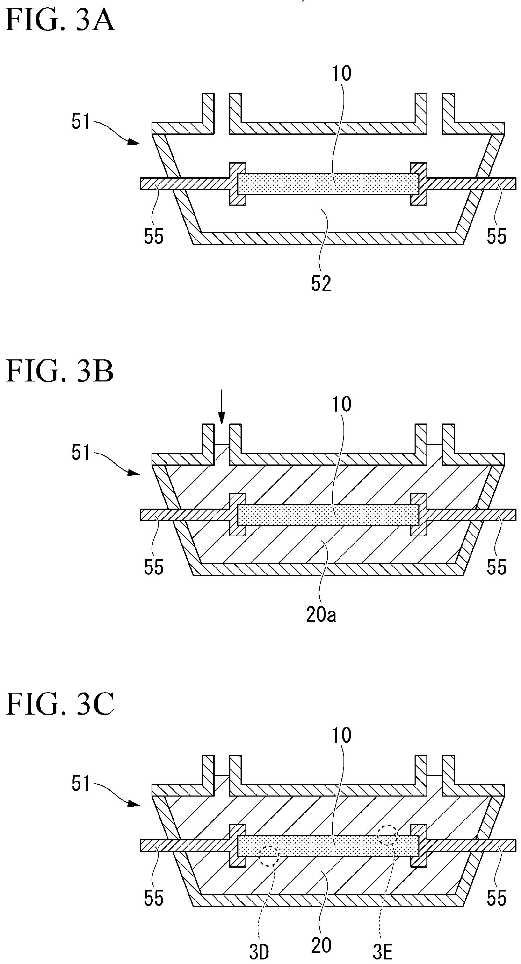

Hereinafter, a method of manufacturing the composite heat transfer member 1 according to this embodiment will be described with reference to Figs. 3A to 3E.

First, as shown in Fig. 3A, fixtures 55 are attached to both end portions of the plate 10, and these are installed in a cavity 52 of a casting mold 51.

Next, as shown in Fig. 3B, a molten or semi-molten metal 20a is poured into the cavity 52 of the casting mold 51.

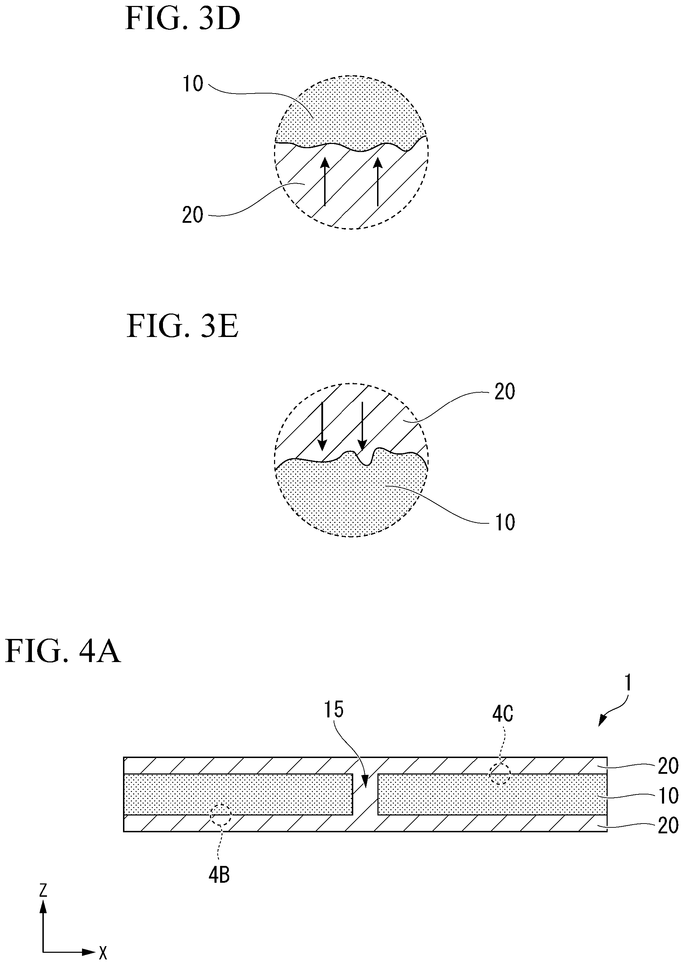

Then, as shown in Fig. 3C, the temperature of the metal 20a constituting the cast body 20 is reduced to about room temperature to form the cast body 20 covering the surface of the plate 10 other than the parts to which the fixtures 55 are attached. In this case, due to a difference in shrinkage between the cast body 20 and the plate 10 caused due to a difference in the thermal expansion coefficient between the cast body 20 and the plate 10, the cast body 20 presses the surface of the plate 10. Accordingly, as shown in Figs. 3D and 3E, the cast body 20 enters the irregularities formed on the main surface of the plate 10. In Figs. 3D and 3E, the arrows indicate that the cast body 20 presses the surface of the plate 10.

By finishing to a predetermined size by machining or the like, the composite heat transfer member 1 according to this embodiment is manufactured.

According to the composite heat transfer member 1 of this embodiment configured as described above and the method of manufacturing the composite heat transfer member 1, since the surface of the plate 10 made of a carbonaceous material formed of a composite containing graphite particles and graphene aggregates formed by depositing a single layer or multiple layers of graphene is covered with the metal cast body 20, the cast body 20 is in surface contact with the surface of the plate 10, and due to a difference in shrinkage between the cast body 20 and the plate 10 during the solidification of the metal constituting the cast body 20, the cast body 20 presses the surface of the plate.

Accordingly, the cast body 20 is strongly adhered to the surface of the plate 10. Therefore, the heat resistance at a joining interface between the cast body 20 and the plate 10 is reduced, and the thermal conductivity of the composite heat transfer member 1 can thus be improved.

In this embodiment, since the carbonaceous member constituting the plate 10 contains graphene aggregates formed by depositing a single layer or multiple layers of graphene, and flat graphite particles, and has a structure in which the flat graphite particles are laminated with the graphene aggregates as a binder so that the basal surfaces of the graphite particles overlap with one another, and the basal surfaces of the flat graphite particles are oriented in one direction, the thermal conductivity in a direction in which the basal surfaces of the graphite particles expand is increased, and heat can be efficiently transferred.

In addition, in this embodiment, in a case where the carbonaceous material constituting the plate 10 has a structure in which the graphite particles and the graphene aggregates are laminated in a direction orthogonal to the thickness direction of the plate 10, the heat conduction property in the thickness direction of the plate 10 is particularly excellent, and heat can be efficiently transferred from one surface of the plate 10 to the other surface side.

Furthermore, in this embodiment, in a case where the cast body 20 is made of pure magnesium, a magnesium alloy, pure aluminum, or an aluminum alloy, the composite heat transfer member 1 can be reduced in weight and can be improved in heat conduction property.

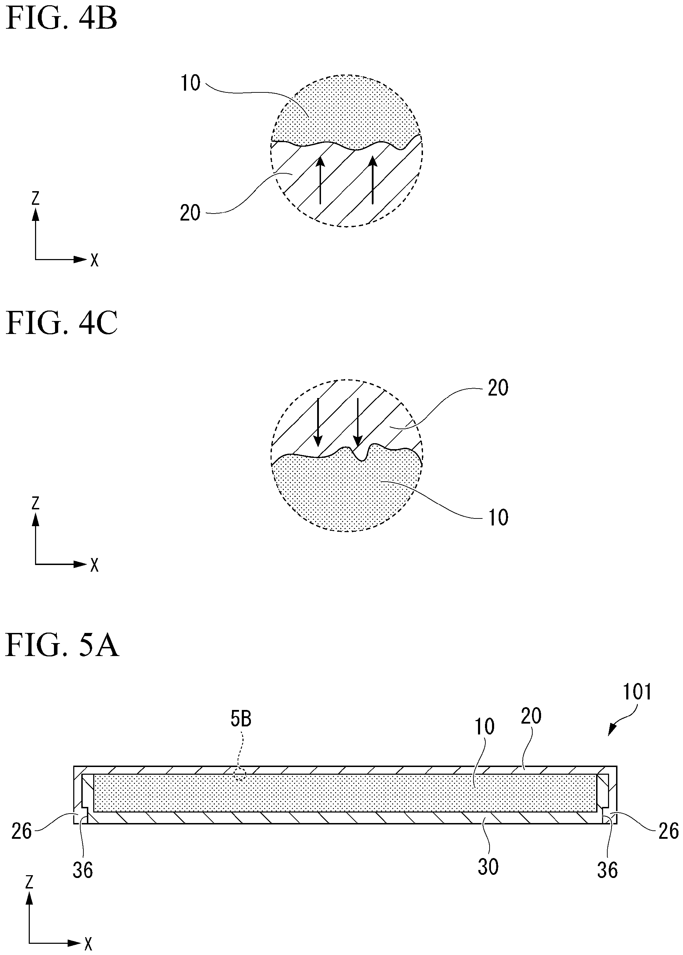

The composite heat transfer member 1 according to this embodiment may have a structure in which, as shown in Fig. 4A, the plate 10 is provided with a through-hole 15 and a part of the cast body 20 fills the through-hole 15. In the composite heat transfer member 1 having the above configuration, as shown in Figs. 4B and 4C, the cast body 20 enters the irregularities formed on the main surface of the plate 10, and a part of the cast body 20 fills the through-hole 15. In Figs. 4B and 4C, the arrows indicate that the cast body 20 presses the surface of the plate 10.

With such a configuration, the plate 10 and the cast body 20 can be more firmly joined. In addition, heat is efficiently transferred in the thickness direction of the plate 10 by the cast body 20 filling the through-hole 15.

### (Second Embodiment)

Next, a second embodiment of the present invention will be described. The same members as those in the first embodiment will be denoted by the same reference signs, and detailed description thereof will be omitted.

As shown in Fig. 5A, a composite heat transfer member 101 according to the embodiment of the present invention has a plate 10 of a carbonaceous material formed of a composite containing graphite particles and graphene aggregates formed by depositing a single layer or multiple layers of graphene, a tray 30 accommodating the plate 10, and a metal cast body 20 covering a surface of the tray 30 accommodating the plate 10.

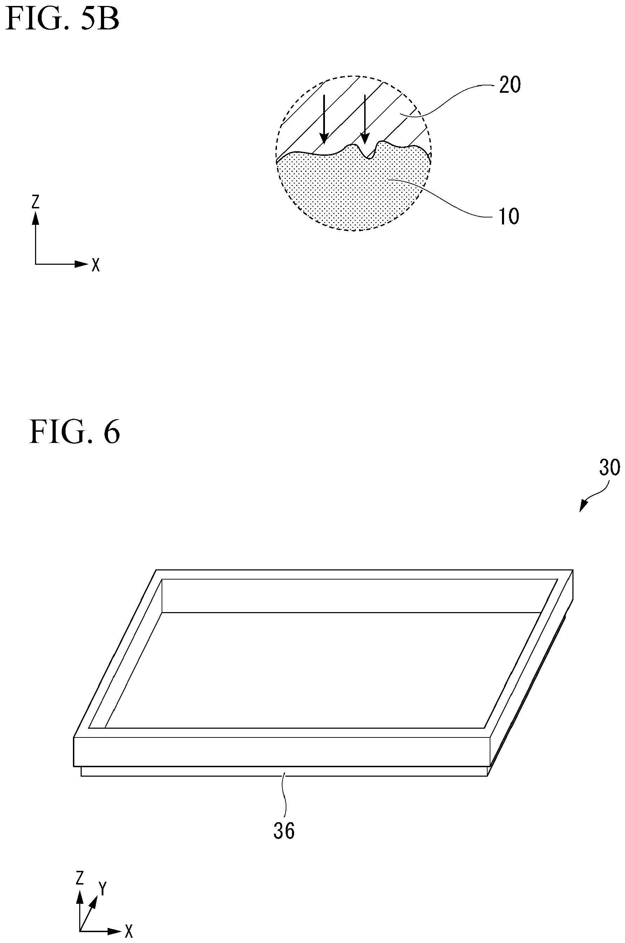

In this embodiment, as shown in Fig. 2, the carbonaceous member constituting the plate 10 contains graphene aggregates formed by depositing a single layer or multiple layers of graphene, and flat graphite particles, and has a structure in which the flat graphite particles are laminated with the graphene aggregates as a binder so that the basal surfaces of the graphite particles overlap with one another. In addition, as shown in Fig. 5B, the cast body 20 enters the irregularities formed on a main surface of the plate 10, and thus the plate 10 and the cast body 20 are firmly joined. In Fig. 5B, the arrows indicate that the cast body 20 presses the surface of the plate 10.

As shown in Fig. 6, the tray 30 is a bottomed metal container having an open top surface. In addition, a recessed portion 36 is provided on the lower side of an outer side surface of the tray 30.

The metal constituting the tray 30 is not particularly limited, and pure magnesium, a magnesium alloy, pure aluminum, or an aluminum alloy can be applied. In this embodiment, the tray 30 is made of a magnesium alloy containing aluminum and zinc and having a thermal conductivity of 51 to 100 W/(m·K).

Here, the cast body 20 is configured to cover at least the exposed surface of the plate 10.

In this embodiment, the cast body 20 is configured to cover the exposed surface of the plate 10 and the outer side surface of the tray 30. In addition, as shown in Fig. 5A, a projecting portion 26 of the cast body 20 is fitted into the recessed portion 36 formed on the lower side of the outer side surface of the tray 30.

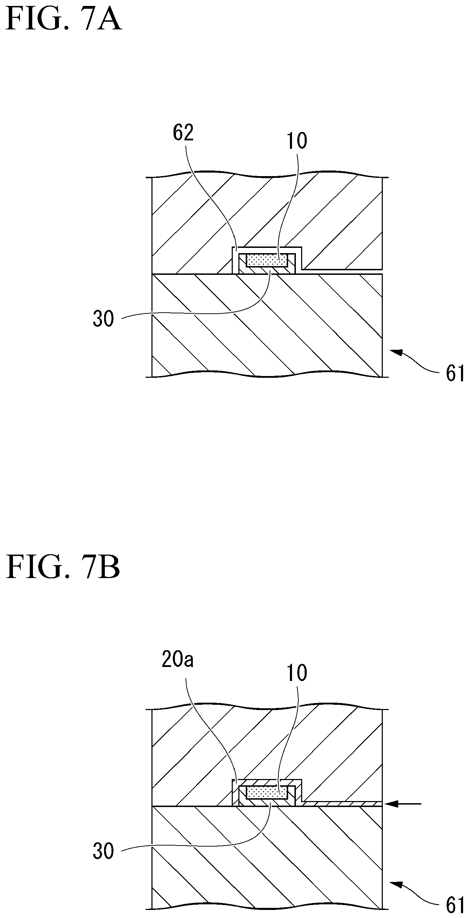

Hereinafter, a method of manufacturing the composite heat transfer member 101 according to this embodiment will be described with reference to Figs. 7A to 7E.

First, as shown in Fig. 7A, the tray 30 accommodating the plate 10 is disposed in a cavity 62 of a metal die 61 of a casting device.

Next, as shown in Fig. 7B, a molten or semi-molten metal 20a is poured into the cavity 62 of the metal die 61. In this embodiment, the metal 20a is press-fitted into the cavity 62 of the metal die 61 by a thixomolding method.

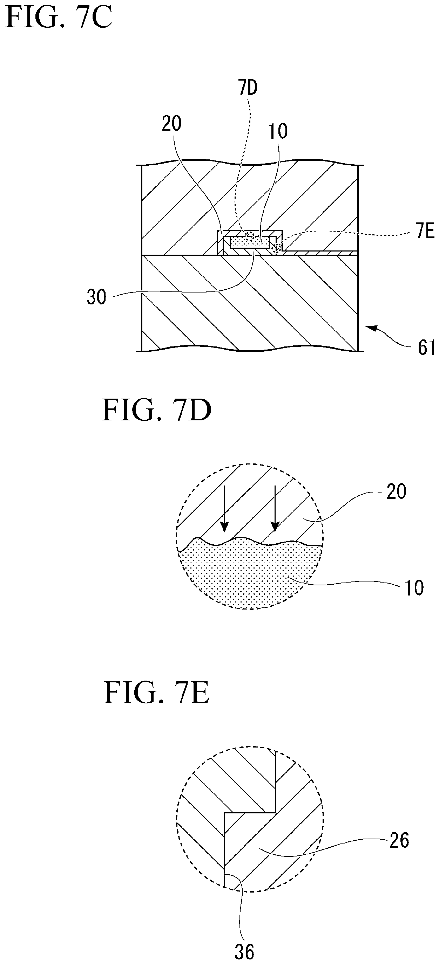

Then, as shown in Fig. 7C, the temperature of the metal constituting the cast body 20 is reduced to about room temperature to form the cast body 20 covering the exposed surface of the plate 10 and the outer side surface of the tray 30 in a state in which the plate 10 is accommodated in the tray 30. In this case, due to a difference in shrinkage between the cast body 20 and the plate 10 caused due to a difference in the thermal expansion coefficient between the cast body 20 and the plate 10, the cast body 20 presses the surface (exposed surface) of the plate 10. Accordingly, as shown in Fig. 7D, the cast body 20 enters the irregularities formed on the exposed surface of the plate 10. In Fig. 7D, the arrows indicate that the cast body 20 presses the surface of the plate 10. Meanwhile, the difference in the thermal expansion coefficient between the cast body 20 and the tray 30 is small. Therefore, as shown in Fig. 7E, the projecting portion 26 of the cast body 20 does not press the recessed portion 36 of the tray 30.

By finishing to a predetermined size by machining or the like, the composite heat transfer member 101 according to this embodiment is manufactured.

According to the composite heat transfer member 101 of this embodiment configured as described above and the method of manufacturing the composite heat transfer member 101, since the plate 10 of a carbonaceous material formed of a composite containing graphite particles and graphene aggregates formed by depositing a single layer or multiple layers of graphene is accommodated in the metal tray 30, and the exposed surface of the plate 10 and the side surface of the tray 30 are covered with the metal cast body 20, the cast body 20 is in surface contact with the surface of the plate 10, and due to a difference in shrinkage between the cast body 20 and the plate 10 during the solidification of the metal constituting the cast body 20, the cast body 20 presses the surface of the plate.

Accordingly, the cast body 20 is strongly adhered to the surface of the plate 10, the heat resistance at a joining interface between the cast body 20 and the plate 10 is reduced, and the thermal conductivity of the composite heat transfer member 101 can thus be improved.

In this embodiment, since the carbonaceous member constituting the plate 10 contains graphene aggregates formed by depositing a single layer or multiple layers of graphene, and flat graphite particles, and has a structure in which the flat graphite particles are laminated with the graphene aggregates as a binder so that the basal surfaces of the graphite particles overlap with one another, and the basal surfaces of the flat graphite particles are oriented in one direction, the thermal conductivity in a direction in which the basal surfaces of the graphite particles expand is increased, and heat can be efficiently transferred.

In addition, in this embodiment, since the plate 10 made of a carbonaceous material is accommodated in the metal tray 30, it is possible to prevent the relatively brittle plate 10 from being damaged during handling. Therefore, it is possible to stably manufacture the composite heat transfer member 101 according to this embodiment.

Furthermore, in this embodiment, since the projecting portion 26 of the cast body 20 is fitted into the recessed portion 36 of the tray 30, it is possible to prevent the cast body 20 from coming off the tray 30.

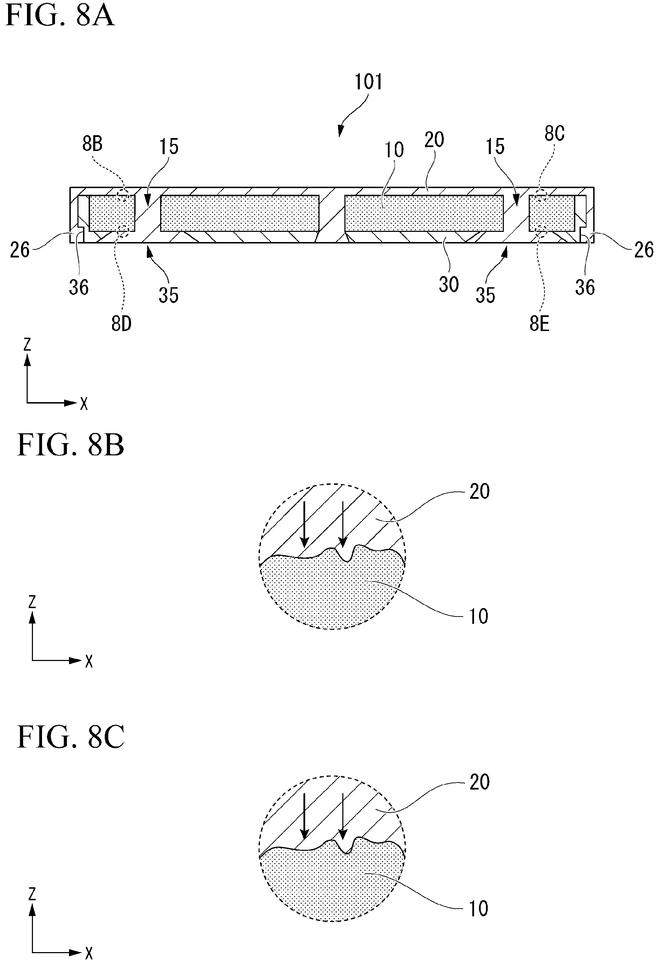

The composite heat transfer member according to this embodiment may have a structure in which, as shown in Fig. 8A, the plate 10 is provided with a through-hole 15, and the tray 30 is provided with an opening portion 35 communicating with the through-hole 15 of the plate 10 so that a part of the cast body 20 fills the through-hole 15 and the opening portion 35.

With such a configuration, the plate 10, the tray 30, and the cast body 20 can be more firmly joined. In addition, heat is efficiently transferred in the thickness direction of the plate 10 by the cast body 20 filling the through-hole 15 and the opening portion 35.

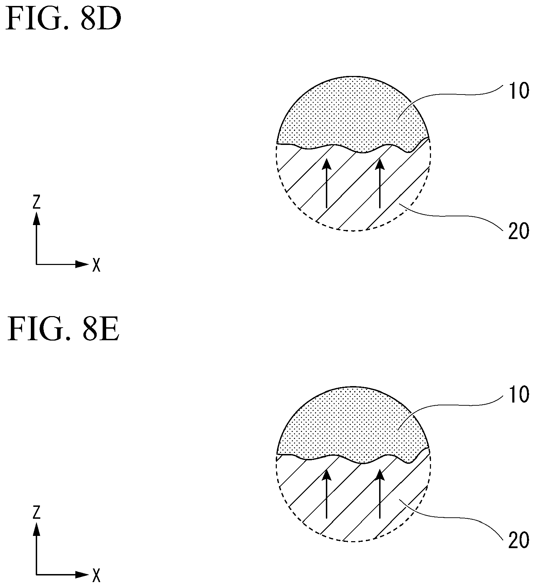

As shown in Fig. 8A, it is preferable that the opening area of the opening portion 35 of the tray 30 be larger than the area of the through-hole 15 of the plate 10. In this case, it is preferable that the back surface side of the through-hole 15 have an undercut shape (retaining shape). In this case, as shown in Figs. 8B, 8C, 8D, and 8E, the cast body 20 is filled around the through-hole 15, and the adhesion between the cast body 20 and the plate 10 is further improved. In Figs. 8B, 8C, 8D, and 8E, the arrows indicates that the cast body 20 presses the surface of the plate 10.

The embodiments of the present invention have been described as above, but the present invention is not limited thereto, and can be appropriately changed without departing from the technical ideas of the present invention.

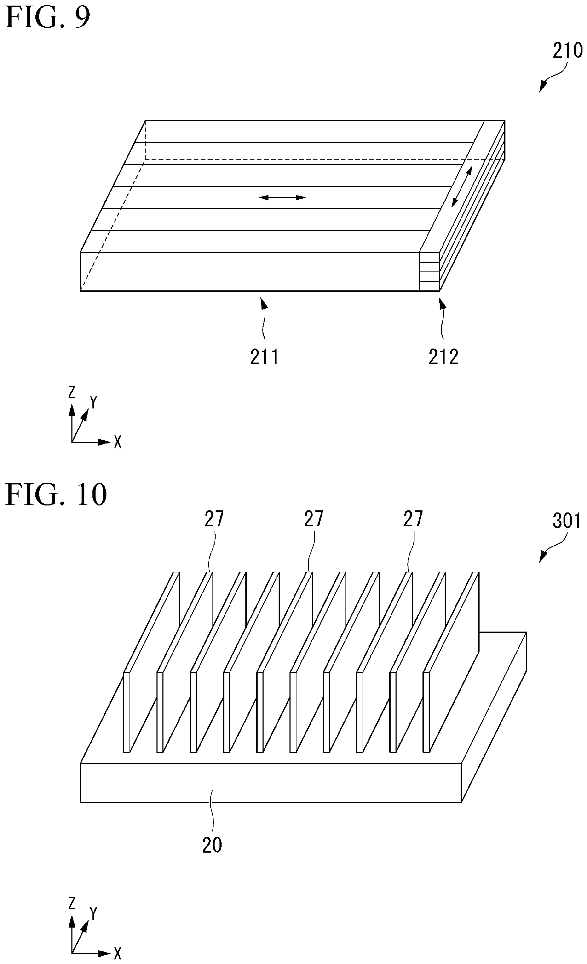

Instead of the plate described in this embodiment, a plate having a region where graphite particles and graphene are laminated in different directions may be used. For example, a plate 210 shown in Fig. 9 has a first laminate 211 formed of a carbonaceous material having a structure in which graphite particles and graphene aggregates are laminated in a first direction orthogonal to a thickness direction of the plate 210, and a second laminate 212 formed of a carbonaceous material having a structure in which graphite particles and graphene aggregates are laminated in a second direction parallel to the thickness direction of the plate 210, and has a structure in which the first laminate 211 and the second laminate 212 are in contact with each other in a third direction orthogonal to the first direction and the second direction.

In this plate 210, as shown in Fig. 9, heat is efficiently transferred in an X direction in the region composed of the first laminate 211, and efficiently transferred in a Y direction in the region composed of the second laminate 212. Accordingly, it is possible to control the transfer direction of heat from a heating element placed on the composite heat transfer member.

In addition, as in a composite heat transfer member 301 shown in Fig. 10, fins 27 may be provided on a cast body 20. In this case, by providing the fins 27 on the cast body 20 covering a surface of a plate, heat radiation characteristics can be improved.

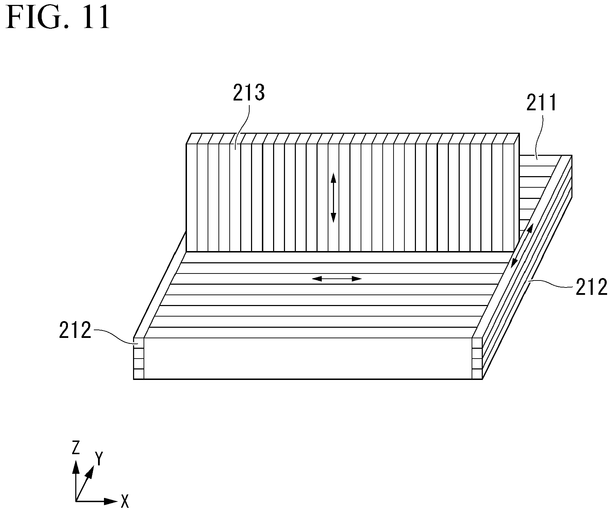

As shown in Fig. 11, a plate 210 may have, together with the first laminate 211 and the second laminate 212 described above, a third laminate 213 formed of a carbonaceous material having a structure in which graphite particles and graphene aggregates are laminated in a third direction, a cast body 20 may cover a surface of the third laminate 213, the third laminate 213 may be configured to be in contact with the first laminate 211 and to be erected from the first laminate 211, and the third laminate 213 may be used as an internal structure of the fins 27.

### INDUSTRIAL APPLICABILITY

According to the present invention, it is possible to provide a composite heat transfer member in which a plate of a carbonaceous material formed of a composite containing graphene and graphite particles and a metal cast body are strongly adhered to each other to efficiently conduct heat, and a method of manufacturing the composite heat transfer member.

### REFERENCE SIGNS LIST

1,101,301: Composite heat transfer member
10,210: Plate
15: Through-hole
20: Cast body
26: Projecting portion
27: Fin
30: Tray
35: Opening portion
36: Recessed portion
211: First laminate
212: Second laminate
213: Third laminate

## Claims

1. A composite heat transfer member, comprising:
a plate; and
a metal cast body covering a surface of the plate,
wherein the plate is made of a carbonaceous material formed of a composite containing graphite particles and graphene aggregates formed by depositing a single layer or multiple layers of graphene.

2. The composite heat transfer member according to Claim 1,
wherein the carbonaceous material contains graphene aggregates formed by depositing a single layer or multiple layers of graphene, and flat graphite particles, and has a structure in which the flat graphite particles are laminated with the graphene aggregates as a binder so that basal surfaces of the graphite particles overlap with one another, and the basal surfaces of the flat graphite particles are oriented in one direction.

3. The composite heat transfer member according to Claim 1 or 2,
wherein the plate is provided with a through-hole, and a part of the cast body fills the through-hole.

4. The composite heat transfer member according to any one of Claims 1 to 3,
wherein the plate is accommodated in a metal tray, and the cast body covers at least an exposed surface of the plate.

5. The composite heat transfer member according to Claim 4,
wherein the plate is provided with a through-hole, the tray is provided with an opening portion communicating with the through-hole of the plate, and a part of the cast body fills the opening portion and the through-hole.

6. The composite heat transfer member according to Claim 4 or 5,
wherein the tray and the cast body are made of the same metal.

7. The composite heat transfer member according to any one of Claims 1 to 6,
wherein fins are provided on the cast body.

8. The composite heat transfer member according to any one of Claims 1 to 7,
wherein the cast body is made of pure magnesium, a magnesium alloy, pure aluminum, or an aluminum alloy.

9. The composite heat transfer member according to any one of Claims 1 to 8,
wherein the carbonaceous material constituting the plate has a structure in which the graphite particles and the graphene aggregates are laminated in a direction orthogonal to a thickness direction of the plate.

10. The composite heat transfer member according to any one of Claims 1 to 8,
wherein the plate has a first laminate formed of a carbonaceous material having a structure in which the graphite particles and the graphene aggregates are laminated in a first direction orthogonal to a thickness direction of the plate, and a second laminate formed of a carbonaceous material having a structure in which the graphite particles and the graphene aggregates are laminated in a second direction parallel to the thickness direction of the plate, and
the first laminate and the second laminate are in contact with each other in a third direction orthogonal to the first direction and the second direction.

11. The composite heat transfer member according to Claim 10,
wherein a third laminate formed of a carbonaceous material having a structure in which the graphite particles and the graphene aggregates are laminated in the third direction is provided, the cast body covers a surface of the third laminate, and the third laminate is in contact with the first laminate and erected from the first laminate in the second direction.

12. A method of manufacturing a composite heat transfer member, the method comprising:
a step of disposing, in a cavity of a casting mold, a plate made of a carbonaceous material formed of a composite containing graphite particles and graphene aggregates formed by depositing a single layer or multiple layers of graphene; and
a step of supplying a molten or semi-molten metal into the cavity to form a cast body of the metal, thereby covering the plate with the cast body.

13. The method of manufacturing a composite heat transfer member according to Claim 12,
wherein the carbonaceous material contains graphene aggregates formed by depositing a single layer or multiple layers of graphene, and flat graphite particles, and has a structure in which the flat graphite particles are laminated with the graphene aggregates as a binder so that basal surfaces of the graphite particles overlap with one another, and the basal surfaces of the flat graphite particles are oriented in one direction.

14. The method of manufacturing a composite heat transfer member according to Claim 12 or 13,
wherein in the step of disposing the plate in the cavity, the plate is disposed in the cavity in a state in which the plate is accommodated in a metal tray, and
in the step of covering a surface of the plate with the cast body, an upper surface of the plate and an outer side surface of the tray are covered with the cast body.
